Europäisches Patentamt

European Patent Office

Office européen des brevets

(19)

(11) Numéro de publication: **0 103 806**
**B1**

(12) **FASCICULE DE BREVET EUROPEEN**

(45) Date de publication du fascicule du brevet: **07.01.87**

(21) Numéro de dépôt: **83108764.8**

(22) Date de dépôt: **06.09.83**

(51) Int. Cl.⁴: **G 01 R 31/26, G 01 N 27/00**

(54) **Procédé et dispositif pour étudier des caractéristiques physiques d'une plaquette semi-conductrice.**

(30) Priorité: **08.09.82 FR 8215215**

(43) Date de publication de la demande:
**28.03.84 Bulletin 84/13**

(45) Mention de la délivrance du brevet:
**07.01.87 Bulletin 87/02**

(84) Etats contractants désignés:
**BE CH DE FR GB IT LI NL**

(56) Documents cités:
**CH-A- 543 098**
**FR-A-2 344 847**

**IBM TECHNICAL DISCLOSURE BULLETIN, vol. 24, no. 10, mars 1982, pages 5150-5151, New York, US**
**D. W. ORMOND JR.: "Dielectric defect detector"**

(73) Titulaire: **COMPAGNIE GENERALE D'ELECTRICITE Société anonyme dite:**
**54, rue La Boétie**
**F-75382 Paris Cedex 08 (FR)**

(72) Inventeur: **Barraud, Jean-Yves**
**145, boulevard de Magenta**
**F-75010 Paris (FR)**
Inventeur: **Tourillon, Gérard**
**3, rue Ney Bouffemont**
**F-95570 Moisselles (FR)**
Inventeur: **Arnould, Francois**
**27, route de Limours Ollainville**
**F-91290 Arpajon (FR)**

(74) Mandataire: **Weinmiller, Jürgen et al**
**Lennéstrasse 9**
**D-8133 Feldafing (DE)**

EP 0 103 806 B1

Courier Press, Leamington Spa, England.

**Description**

La présente invention concerne un procédé et un dispositif pour étudier des caractéristiques physiques d'une plaquette semi-conductrice. Le procédé est d'un type consistant successivement

— à appliquer de façon amovible une plaquette semi-conductrice sur le fond d'un récipient isolant muni d'une ouverture, de façon à obturer cette ouverture,

— à disposer un électrolyte dans le récipient, une première face de la plaquette en contact avec l'électrolyte constituant une électrode de travail,

— à maintenir une électrode auxiliaire dans l'électrolyte en regard de l'électrode de travail,

— à relier les deux bornes d'un générateur d'énergie électrique continue respectivement à la deuxième face de la plaquette et à l'électrode auxiliaire,

— et à étudier la première face et un déduire les caractéristiques de la plaquette.

Un procédé de ce type est connu par le document FR—A—2.344.847 (IBM). Dans ce procédé, une plaquette semi-conductrice est appliquée sur la paroi externe du fond d'un récipient muni d'une ouverture, de façon à obturer cette ouverture. L'ouverture est munie d'un anneau sur lequel porte la plaquette. La plaquette est maintenue contre l'anneau par un élément en acier inoxydable s'appuyant sur le fond du récipient. Un électrolyte à base d'acide fluorhydrique est disposé dans le récipient. Les deux bornes d'une source d'alimentation électrique sont reliées respectivement d'une part à l'élément en acier inoxydable, cet élément étant en contact avec la plaquette qui joue le rôle d'électrode principale, et d'autre part à une feuille de platine immergée dans l'électrolyte, qui joue le rôle d'électrode auxiliaire.

Le procédé décrit dans le document précité concerne uniquement la détection de défauts électriques actifs dans un substrat de silicium de type N. Par ailleurs, ce procédé présente des inconvénients. En effet, la surface utile de la plaquette est limitée par celle de l'ouverture du récipient. De plus, le réglage de la pression de l'anneau sur la plaquette pose des problèmes difficiles, notamment lorsque la plaquette a une faible épaisseur: une pression trop faible risque d'entraîner un défaut d'étanchéité du récipient, alors qu'une pression trop forte peut provoquer la rupture de la plaquette. Il y a lieu de noter également que l'élément en acier inoxydable interposé entre la plaquette et la source d'alimentation risque d'introduire des chutes de tension parasites capables de fausser certaines mesures.

La présente invention a pour but de pallier ces inconvénients.

Elle a pour objet un procédé pour étudier des caractéristiques physiques d'une plaquette semi-conductrice, du type spécifié plus haut, caractérisé en ce que

— la paroi interne du fond du récipient étant sensiblement plane, l'application de façon amovible d'une plaquette dudit matériau sur le fond du récipient s'effectue par l'intermédiaire d'une couche conductrice déposée sur la deuxième face de la plaquette, cette application étant obtenue en faisant le vide dans des rainures ménagées sur cette paroi interne, le vide étant réalisé à travers des canalisations logées dans le fond du récipient et faisant communiquer ces rainures avec un système de pompage situé à l'extérieur du récipient, l'obturation de l'ouverture du récipient étant étanche à l'électrolyte

— et la liaison entre le générateur et les deux électrodes de travail et auxiliaire est maintenue pendant un intervalle de temps prédéterminé, la liaison entre le générateur et la deuxième face de la plaquette consistant à relier ladite couche conductrice au générateur, à travers ladite ouverture, la détermination des caractéristiques s'effectuant au bout de l'intervalle de temps prédéterminé.

La présente invention a aussi pour objet un dispositif pour mettre en oeuvre ce procédé, caractérisé en ce qu'il comporte

— un récipient muni d'une ouverture, dont la paroi interne du fond, sensiblement plane, comporte des rainures, le fond du récipient comportant des canalisations faisant communiquer ces rainures avec l'extérieur du récipient,

— un système de pompage relié aux canalisations pour faire le vide dans les rainures, afin d'appliquer de façon amovible sur la paroi interne du fond du récipient une plaquette semiconductrice par l'intermédiaire d'une couche conductrice déposée sur une face de cette plaquette,

— des moyens amovibles pour disposer une électrode auxiliaire dans le récipient,

— des moyens pour introduire un électrolyte dans le récipient et le retirer,

— et des moyens pour relier électriquement une borne du générateur à l'électrode auxiliaire, l'autre borne du générateur étant reliée, à travers l'ouverture du récipient, à ladite couche conductrice.

Une forme particulière d'exécution de l'objet de la présente invention est décrite ci-dessous, à titre d'exemple, en référence aux dessins annexés, dans lesquels

— la figure 1 représente en coupe une cellule faisant partie d'un mode de réalisation du dispositif selon l'invention

— et la figure 2 représente schématiquement l'autre partie du dispositif dont la cellule est illustrée sur la figure 1.

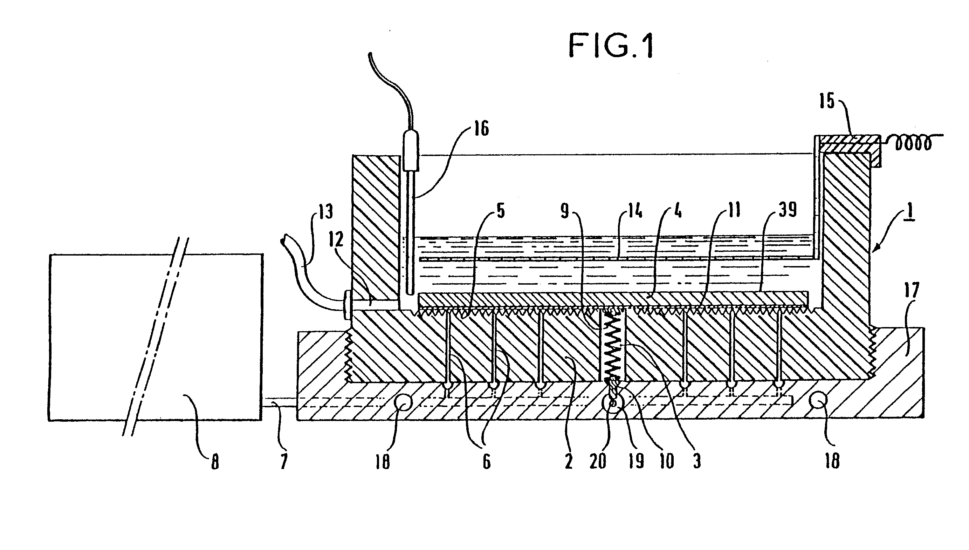

Sur la figure 1, est représenté un récipient 1 en polytétrafluoréthylène muni d'un fond plat 2 comportant une ouverture centrale 3. Une plaquette de silicium 4 à étudier est posée horizontalement sur la face interne du fond 2 du récipient 1, de façon à recouvrir l'ouverture 3. La face interne du fond 2 est muni de rainures telles que 5, par exemple en forme de cercles concentriques par rapport à l'ouverture 3. Le fond du récipient comporte des canalisations internes telles que 6 faisant communiquer ces rainures avec une canalisation 7 située à l'extérieur du récipient, la canalisation 7 étant reliée à un système de pompage 8.

A l'intérieur de l'ouverture 3 est logé verticalement un ressort hélicoïdal 9 dont l'extrémité supérieure porte sur la face de la plaquette 4 en contact avec le fond du récipient 1. Le ressort 9 est réalisée en un matériau conducteur électrique et son extrémité inférieure est reliée à une borne 10. La face de la plaquette 4 en contact avec le ressort 9 est recouverte d'une couche d'aluminium conductrice extrêmement mince 11.

Un canal 12 traversant la paroi latérale du récipient 1 est reliée extérieurement à une canalisation 13 en polytétrafluoréthylène.

Une électrode auxiliaire 14 en platine, fixée sur un support isolant 15 simplement posé sur le bord supérieur du récipient 1, est disposée horizontalement à l'intérieur du récipient en regard de la plaquette 4. Une électrode de référence 16 au calomel est disposée verticalement dans le récipient 1.

Un support métallique 17, de préférence en acier inoxydable, est fixé extérieurement sur le fond du récipient 1 par exemple par vissage. Le support 17 est muni de canaux internes 18 aptes à recevoir un liquide de refroidissement, et d'un canal 19 dans lequel est disposé un fil de connexion électrique 20 relié à la borne 10.

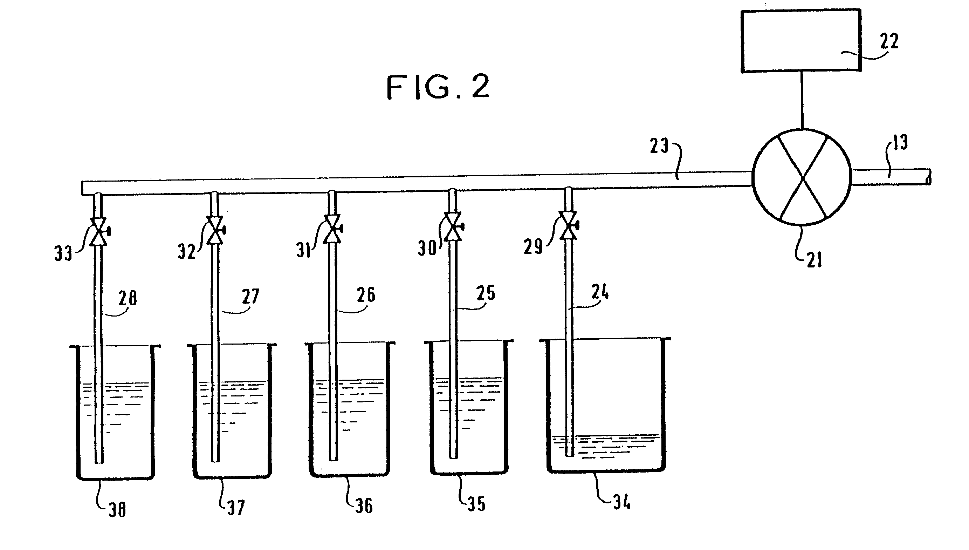

Sur la figure 2, est représentée une pompe électrique à liquide 21 dont le corps est réalisé en polytétrafluoréthylène. Cette pompe est alimentée par un dispositif d'alimentation électrique commandable 22. La pompe 21 comporte une sortie de liquide reliée à l'extrémité libre de la canalisation 13 et une autre sortie reliée à une extrémité d'une canalisation 23 dont l'autre extrémité est fermée. De la canalisation 23 partent, à partir de la pompe 21, cinq dérivations 24 à 28 munies respectivement de vannes de commande 29 à 33. Les extrémités libres des dérivations aboutissent respectivement à l'intérieur de réservoirs 34 à 38, parmi lesquels le réservoir 34 sert de rebut et les autres d'alimentation en électrolyte ou liquide de lavage. La canalisation 23, les dérivations 24 à 28, les corps des vannes 29 à 33 et les réservoirs 34 à 38 sont réalisés en polytétrafluoréthylène.

Le dispositif décrit ci-dessus et illustré par les figures 1 et 2 fonctionne de la manière suivante.

On dépose d'abord, sur une face plane de la plaquette de silicium 4 à analyser, la couche conductrice d'aluminium 11. Cette couche peut être déposée, de manière connue, par évaporation sous vide, puis traitée thermiquement à 420° C pendant un quart d'heure sous atmosphère inerte.

Ensuite, la couche 11 de la plaquette reposant sur la face interne du fond du récipient, on met en marche le système de pompage 8 de façon à faire le vide dans les rainures 5. La plaquette est alors appliquée sur le fond du récipient par une pression répartie sur toute la surface de cette plaquette. En même temps, un bon contact électrique s'établit entre la portion de la couche 11 située en regard de l'ouverture 3 et l'extrémité supérieure du ressort 9, par compression de ce ressort.

Si l'on désire mettre en évidence les défauts électriques de la plaquette 4, on remplit le réservoir 35 d'un mélange d'acide fluorhydrique FH et d'alcool, ce mélange comprenant de préférence une solution à 5% d'acide fluorhydrique et un volume égal d'alcool. La pompe 21 est d'un type capable de faire circuler un liquide dans le sens des réservoirs au récipient 1 ou en sens inverse. Après ouverture de la vanne 30, on commande le circuit 22 pour que le mélange contenu dans le réservoir 35 s'écoule dans le récipient et on arrête la pompe 21 lorsque le mélange contenu dans le récipient 1 recouvre l'électrode auxiliaire 14. Grâce au vide maintenu dans les rainures 5 par le système de pompage 8, la plaquette 4 obture l'ouverture 3 de façon étanche au mélange.

On obtient ainsi une cellule photo-électrochimique comprenant une électrode de travail constituée par la plaquette 4, une électrode auxiliaire 14, une électrode de référence 16, et un électrolyte constitué par le mélange contenu dans le récipient 1.

On connecte alors électriquement l'électrode 14 et le fil de connexion 20 aux bornes d'un générateur d'énergie électrique continue non représenté, de façon que l'électrode de travail 4 soit portée à un potentiel négatif d'environ 0,5 volt par rapport à celui de l'électrode 14. L'électrode de référence 16 permet de déterminer le potentiel de l'électrode de travail 4.

Si c'est nécessaire, on relie les canalisations 18 à un système non représenté capable de faire circuler dans ces canalisations un liquide de refroidissement afin de maintenir la température de l'électrolyte à la valeur désirée.

On maintient les électrodes sous tension pendant 60 minutes environ. On observe alors des zones sombres qui apparaissent sur la face 39 de la plaquette en contact avec l'électrolyte. La demanderesse a vérifié que ces zones sombres de la plaquette présentent une faible réponse électrique aux excitations lumineuses, tandis que les zones d'éclat inchangé présentent une réponse électrique normale.

L'électrode auxiliaire amovible 14 peut être retirée du récipient 1, de façon à permettre de photographier la face 39 de la plaquette dont l'aspect est représentatif des caractéristiques électriques locales de la plaquette.

Si on ne désire par obtenir d'autres caractéristiques de la plaquette, on retire l'électrolyte du récipient 1 en fermant les vannes 30 à 33 (figure 2), la vanne 29 étant ouverte, et en commandant par le dispositif 22 le fonctionnement de la pompe 21 en sens inverse, ce qui permet d'enlever l'électrolyte du récipient 1 et de le transporter dans le réservoir de rebut 34.

On ferme alors la vanne 29 et on ouvre la vanne 32. Le réservoir 37 contient de l'alcool $CH_3CH_2OH$. On actionne la pompe 21 dans le sens convenable de façon à mettre un peu d'alcool dans le récipient 1 pour effectuer un lavage de la face 39 de la plaquette. Après rejet de l'alcool dans le réservoir 34, on arrête le fonctionnement du système de pompage 8, de façon à pouvoir détacher la plaquette du fond du réservoir. Les zones révélées de la face 39 sont enlevées par un simple essuyage. La couche 11 peut être enlevée de la manière suivante: on fixe la plaquette en sens inverse sur le fond du récipient à l'aide du système de pompage et on introduit dans le récipient une solution équivolumique d'acide fluorhydrique et d'acide chromique contenue dans le réservoir 38; la couche ainsi attaquée chimiquement peut être enlevée par un simple essuyage après un nouveau détachement de la plaquette. La plaquette de silicium 4 n'a donc pas été altérée par la détermination de ses caractéristiques électriques.

On suppose maintenant qu'on désire déterminer les caractéristiques cristallographiques d'une plaquette de silicium prélevée d'une chaîne de fabrication.

Le dépôt de la couche d'aluminium 11 sur une face de la plaquette et la fixation de cette plaquette sur le fond du récipient 1, à l'aide du système de pompage 8, s'effectue d'une manière identique à celle décrite précédemment.

De même, on dépose dans le récipient 1 une quantité suffisante de l'électrolyte contenu dans le réservoir 35 de façon à recouvrir l'électrode auxiliaire 14.

Puis, on connecte électriquement les électrodes de la cellule ainsi constituée à un générateur d'énergie électrique continue, de façon que l'électrode de travail 4 soit portée à un potentiel positif d'environ 10 volts par rapport à celui de l'électrode 14.

On maintient les électrodes sous tension pendant 25 minutes environ.

On constate alors que la face 39 de la plaquette de silicium prend un aspect multicolore. En effet, lors de l'attaque électrochimique, le silicium superficiel est dissous à l'état divalent avec formation d'une couche de silicium poreux recouvert d'un film d'oxyde. En solution diluée, les molécules d'acide fluorhydrique sont trop peu nombreuses pour dissoudre l'oxyde.

Ce dernier forme un film résistant d'indice de réfraction différent de celui du silicium et joue le rôle d'une lame mince dont l'épaisseur dépend de l'orientation du grain de cristal attaqué. Les épaisseurs d'oxyde sont situées dans l'échelle 4000 à 15000 des teintes de Newton. Il existe donc une corrélation reproductible entre les épaisseurs et les couleurs, de sorte que:
— une coloration jaune apparait pour les plans cristallographiques 1.1.1.
— une coloration verte apparait pour les plans cristallographiques 2.1.1.
— une coloration indigo apparait pour les plans cristallographiques 3.1.1.
— et une coloration mauve rosée apparait pour les plans cristallographiques 3.3.1.

Bien entendu, comme dans le cas précédent, la face multicolore de la plaquette de silicium peut être photographiée.

Le procédé permet, par simple observation de cette face, de déceler localement la nature des défauts cristallins, et de déterminer la taille et l'orientation des grains.

Après la détermination des caractéristiques cristallographiques, on peut remettre la plaquette de silicium dans son état initial par une attaque avec la solution équivolumique d'acide fluorhydrique et d'acide chromique contenue dans le récipient 38, cette attaque étant suivie d'un lavage à l'alcool (contenu dans le récipient 37).

Il est possible de déterminer successivement les caractéristiques électriques et cristallographiques d'une même plaquette de silicium, sans qu'il soit besoin de remplacer l'électrolyte utilisé pour la détermination des caractéristiques électriques. Dans ce cas, le dispositif de polarisation électrique des électrodes comporte de préférence une source de tension variable et un inverseur de polarité.

Le dispositif illustré par les figures 1 et 2 présente l'avantage de pouvoir être également utilisé pour déterminer les caractéristiques photovoltaïques d'une plaquette de silicium.

Après avoir appliqué la plaquette sur le fond du récipient de la manière décrite précédemment, on introduit dans le récipient un volume convenable d'un électrolyte constitué par une solution d'acide perchlorique contenue dans le réservoir 36, en appliquant à l'électrode de travail une polarisation positive de $0^V5$ par rapport à l'électrode auxiliaire 14. On mesure alors la tension et le courant entre les électrodes en excitant la face 39 de la plaquette par un rayonnement monochromatique, l'électrode auxiliaire comportant, dans ce cas, une ouverture pour laisser passer le rayonnement. On peut aussi déterminer localement les caractéristiques photovoltaïques de la plaquette en concentrant le rayonnement d'excitation sur une petite portion de la surface 39, la portion illuminée pouvant être déplacée sur toute la surface de la plaquette.

**Revendications**

1. Procédé pour étudier des caractéristiques physiques d'une plaquette semi-conductrice (4), consistant successivement
— à appliquer de façon amovible une plaquette semi-conductrice (4) sur le fond (2) d'un récipient (1) isolant muni d'une ouverture (3), de façon à obturer cette ouverture,
— à disposer un électrolyte dans le récipient, une première face de la plaquette en contact avec l'électrolyte constituant une électrode de travail,
— a maintenir une électrode auxiliaire (14) dans l'électrolyte en regard de l'électrode de travail,
— à relier les deux bornes d'un générateur d'énergie électrique continue respectivement à la deuxième face de la plaquette et à l'électrode auxiliaire (14),
— et à étudier la première face et en déduire les caractéristiques de la plaquette, caractérisé en ce que
— la paroi interne du fond (2) du récipient (1) étant sensiblement plane, l'application de façon amovible d'une plaquette (4) dudit matériau sur le fond (2) du récipient (1) s'effectue par l'intermédiaire d'une couche conductrice (11) déposée sur la deuxième face de la plaquette, cette application étant obtenue en faisant le vide dans des rainures (5) ménagées sur cette paroi interne, le vide étant réalisé à travers des canalisations (6) logées dans le fond (2) du récipient et faisant communiquer ces rainures (5) avec un système de pompage (8) situé à l'extérieur du récipient (1) l'obturation de l'ouverture (3) du récipient étant étanche à l'électrolyte,

— et al liaison entre le générateur et les deux électrodes de travail (4) et auxiliaire (14) est maintenue pendant un intervalle de temps prédéterminé, la liaison entre le générateur et la deuxième face de la plaquette (4) consistant à relier ladite couche conductrice (11) au générateur, à travers ladite ouverture (3), la détermination des caractéristiques s'effectuant au bout de l'intervalle de temps prédéterminé.

2. Procédé selon la revendication 1, caractérisé en ce que la plaquette semi-conductrice est en silicium, et que l'électrolyte est un mélange d'acide fluorhydrique et d'alcool.

3. Procédé selon la revendication 2, caractérisé en ce que l'électrode de travail (4) étant portée par le générateur, par rapport à l'électrode auxiliaire (14), à un potentiel négatif sensiblement égal à 0,5 V, l'intervalle de temps prédéterminé étant de l'ordre de 60 minutes, les caractéristiques électriques locales de la plaquette sont déterminées par examen de zones sombres visibles au bout du temps prédéterminé sur la première face, ces zones sombres correspondant à des zones de mauvaise réponse électrique aux excitations lumineuses.

4. Procédé selon la revendication 2, caractérisé en ce que, l'électrode de travail (4) étant portée par le générateur, par rapport à l'électrode auxiliaire (14), à un potentiel positif sensiblement égal à 10 volts, l'intervalle de temps prédéterminé étant de l'ordre de 25 minutes, les caractéristiques cristallographiques locales de la plaquette sont déterminées par examen de dépôts colorés visibles au bout du temps prédéterminé sur la première face, chaque couleur étant représentative d'un plan cristallographique.

5. Procédé selon la revendication 2, caractérisé en ce que l'électrolyte est constitué d'un mélange équivolumique d'alcool et d'une solution aqueuse contenant 5% d'acide fluorhydrique.

6. Dispositif pour mettre en oeuvre le procédé selon la revendication 1, caractérisé en ce qu'il comporte

— un récipient (1) muni d'une ouverture (3), dont la paroi interne du fond (2), sensiblement plane, comporte des rainures (5), le fond (2) du récipient (1) comportant des canalisations (6) faisant communiquer ces rainures avec l'extérieur du récipient,

— un système de pompage (8) relié aux canalisations (6) pour faire le vide dans les rainures (5), afin d'appliquer de façon amovible sur la paroi interne du fond (2) du récipient (1) une plaquette semi-conductrice (4) par l'intermédiaire d'une couche conductrice (11) déposée sur une face de cette plaquette (4),

— des moyens amovibles (15) pour disposer une électrode auxiliaire (14) dans le récipient (1),

— des moyens (12, 13, 21, 23, 25) pour introduire un électrolyte dans le récipient et le retirer,

— et des moyens pour relier électriquement une borne du générateur à l'électrode auxiliaire, l'autre borne du générateur étant reliée, à travers l'ouverture (3) du récipient (1), à ladite couche conductrice (11).

7. Dispositif selon la revendication 6, caractérisé en ce que la liaison entre l'autre borne du générateur et la couche conductrice (11) comporte un ressort (9) conducteur électrique logé dans ladite ouverture (3), ce ressort étant appliqué par compression sur la couche conductrice (11) lorsque ledit système de pompage (8) est actionné, le ressort étant connecté au générateur.

8. Dispositif selon l'une des revendications 6 et 7, caractérisé en ce que lesdits moyens pour introduire et retirer l'électrolyte comportent un circuit de pompage (13, 21, 23) relié d'une part à un réservoir (35) de l'électrolyte à travers une première vanne (30) et d'autre part à un canal (12) traversant la paroi latérale du récipient (1), ce circuit comprenant une pompe (21) capable de faire circuler l'électrolyte dans le sens du réservoir au récipient ou en sens inverse, une dérivation (24) pour évacuer l'électrolyte étant disposée entre la pompe (21) et la première vanne (30), cette dérivation (24) comprenant en série une deuxième vanne (29).

9. Dispositif selon la revendication 6, caractérisé en ce qu'il comporte en outre un support métallique (17) et des moyens de fixation amovible du fond du récipient sur le support, le support étant muni de canaux internes (18) aptes à contenir un liquide de refroidissement en circulation.

**Patentansprüche**

1. Verfahren zur Untersuchung der physischen Eigenschaften eines Halbleiterplättchens (4), das nacheinander darin besteht

— ein Halbleiterplättchen (4) lösbar auf dem Boden (2) eines mit einer Öffnung (3) versehenen Isolierbehälters (1) anzubringen, so daß diese Öffnung verschlossen wird,

— einen Elektrolyten in den Behälter einzubringen, wobei eine erste, in Kontakt mit dem Elektrolyten stehende Seite des Plättchens eine Arbeitselektrode bildet,

— eine Hilfselektrode (14) im Elektrolyten gegenüber der Arbeitselektrode zu halten,

— die beiden Klemmen eines elektrischen Gleichspannungsgenerator mit der zweiten Seiten des Plättchens bzw. mit der Hilfselektrode (14) zu verbinden

— und die erste Seite zu untersuchen und daraus die Eigenschaften des Plättchens abzuleiten, dadurch gekennzeichnet, daß

— bei einer im wesentlichen ebenen Innenwand des Bodens (2) des Behälters (1) das lösbare Anbringen eines Plättchens (4) aus dem genannten Material auf dem Boden (2) des Behälters (1) über eine auf die zweite Seite des Plättchens aufgebrachte leitende Schicht (11) erfolgt, wobei dieses Anbringen dadurch erhalten wird, daß in in dieser Innenwand angebrachten Nuten (5) ein Vakuum erzeugt wird, das durch im Boden (2) des Behälters angeordnete Kanäle (6) erzeugt wird, die diese Nuten (5) mit einem Pumpsystem (8) verbinden, das außerhalb des Behälters (1) angeordnet ist, wobei der Verschluß der Öffnung (3) des Behälters für den Elektrolyten dicht ist,

— und daß die Verbindung zwischen dem Generator und der Arbeits- (4) und der Hilfselektrode (14) während eines vorbestimmten Zeitintervalls aufrechterhalten wird, wobei die Verbindung zwischen dem Generator und der zweiten Seite des Plättchens (4) darin besteht, daß die leitende Schicht (11) durch die Öffnung (3) hindurch mit dem Generator verbunden wird, wobei die Bestimmung der Eigenschaften am Ende des vorbestimmten Zeitintervalls durchgeführt wird.

2. Verfahren nach Anspruch 1, dadurch gekennzeichnet, daß das Halbleiterplättchen aus Silizium besteht und daß der Elektrolyt eine Mischung aus Fluorhydridsäure und Alkohol ist.

3. Verfahren nach Anspruch 2, dadurch gekennzeichnet, daß die Arbeitselektrode (4) vom Generator in bezug auf die Hilfselektrode (14) auf ein negatives Potential im wesentlichen gleich 0,5 V gebracht wird, daß der vorbestimmte Zeitintervall etwa 60 Minuten beträgt und daß die örtlichen elektrischen Eigenschaften des Plättchens durch Untersuchung der am Ende des vorbestimmten Zeitintervalls auf der ersten Seite sichtbaren dunklen Bereiche bestimmt werden, wobei diese dunklen Bereiche Bereichen schlechten elektrischen Ansprechens auf Lichtanregungen entsprechen.

4. Verfahren nach Anspruch 2, dadurch gekennzeichnet, daß die Arbeitselektrode (4) vom Generator in bezug auf die Hilfselektrode (14) auf ein positives Potential im wesentlichen gleich 10 V gebracht wird, daß der vorbestimmte Zeitintervall etwa 25 Minuten beträgt und daß die örtlichen kristallographischen Eigenschaften des Plättchens durch Untersuchung der am Ende der vorbestimmten Zeit auf der ersten Seite sichtbaren Farbablagerungen bestimmt werden, wobei jede Farbe einer kristallographischen Ebene entspricht.

5. Verfahren nach Anspruch 2, dadurch gekennzeichnet, daß der Elektrolyt aus einer Mischung gleicher Volumen von Alkohol und einer wässrigen Lösung besteht, die 5% Fluorhydridsäure enthält.

6. Vorrichtung zur Anwendung des Verfahrens nach Anspruch 1, dadurch gekennzeichnet, daß sie aufweist

— einen mit einer Öffnung (3) versehenen Behälter (1), dessen im wesentlichen ebene Innenwand des Bodens (2) Nuten (5) aufweist, wobei der Boden (2) des Behälters (1) Kanäle (6) besitzt, die eine Verbindung dieser Nuten nach außen herstellen,

— ein mit den Kanälen (6) verbundenes Pumpsystem (8), um in den Nuten (5) ein Vakuum herzustellen und ein Halbleiterplättchen (4) über eine auf eine Seite dieses Plättchens (4) aufgebrachte leitende Schicht (11) in lösbarer Weise auf die Innenwand des Bodens (2) des Behälters (1) aufzubringen,

— lösbare Mittel (15), um eine Hilfselektrode (14) in dem Behälter (1) anzuordnen,

— Mittel (12, 13, 21, 23, 25), um einen Elektrolyten in den Behälter hinein und wieder herauszubringen,

— und Mittel, um eine Klemme des Generators mit der Hilfselektrode zu verbinden, während die andere Klemme des Generators duch die Öffnung (3) des Behälters (1) mit der leitenden Schicht (11) verbunden wird.

7. Vorrichtung nach Anspruch 6, dadurch gekennzeichnet, daß die Verbindung zwischen der anderen Klemme des Generators und der leitenden Schicht (11) eine in der Öffnung (3) angeordnete elektrisch leitende Feder (9) aufweist, die durch Kompression auf die leitende Schicht (11) drückt, wenn das Pumpsystem (8) aktiviert wird, wobei die Feder mit dem Generator verbunden ist.

8. Vorrichtung nach einem der Ansprüche 6 und 7, dadurch gekennzeichnet, daß die Mittel zum Einführen und zum Herausnehmen des Elektrolyten einen Pumpkreis (13, 21, 23) aufweisen, der einerseits über ein ersten Ventil (30) mit einem Tank (35) des Elektrolyten und andererseits mit einem Kanal (12) verbunden ist, der die Seitenwand des Behälters (1) durchquert, wobei dieser Kreis eine Pumpe (21) enthält, die den Elektrolyten in Richtung vom Tank zum Behälter oder umgekehrt zirkulieren lassen kann, wobei eine Ableitung (24) zum Entfernen des Elektrolyten zwischen der Pumpe (21) und dem ersten Ventil (30) angeordnet ist, die in Reihe ein zweites Ventil (29) aufweist.

9. Vorrichtung nach Anspruch 6, dadurch gekennzeichnet, daß sie außerdem einen metallischen Träger (17) und Mittel zur lösbaren Befestigung des Behälterbodens auf dem Träger aufweist, wobei der Träger mit inneren Kanälen (18) versehen ist, in der eine Kühlflüssigkeit umlaufen kann.

**Claims**

1. A method of investigating the physical characteristics of a semiconductor plate (4), comprising the following consecutive steps:

— removably applying a semiconductor plate (4) to the base (2) of an insulating container (1) having an opening (3), so as to cover this opening,

— placing an electrolyte in the container, a first side of the plate in contact with the electrolyte constituting a working electrode,

— maintaining an auxiliary electrode (14) in position in the electrolyte facing the working electrode,

— connecting the two terminals of a direct current electrical power generator respectively to the second side of the plate and the auxiliary electrode (14),

— and investigating the first side and deducing therefrom the characteristics of the plate, characterized in that

— the inner wall of the base (2) of the container (1) being essentially plane, the removable application of a plate (4) of said material on the base (2) of the container (1) is carried out by means of a conductive layer (11) brought on the second side of the plate, this application being obtained by evacuating grooves (5) formed in this inner wall, the vacuum being obtained through passages (6) located in the base (2) of the container and making these grooves (5) communicate with a pumping system (8) situated outside the container (1), the closing of the opening (3) being electrolyte-tight,

— and the connection between the generator and the working (4) and auxiliary electrodes (14) being maintained during a predetermined time interval, the connection between the generator and the second side of the plate (4) consisting in branching said conductive layer (11) to the generator through said opening (3), the investigation of the characteristics being carried out at the end of the predetermined time interval.

2. A method according to claim 1, characterized in that the semiconductor plate is made of silicium and in that the electrolyte is a mixture of hydrofluoric acid and alcohol.

3. A method according to claim 2, characterized in that, the working electrode (4) being fed by the generator, with respect to the auxiliary electrode (14), with a negative potential of substantially 0,5 V, the predetermined time interval being of the order of 60 minutes, the local electrical characteristics of the plate are determined by examining the dark areas visible on the first side after the predetermined time, these areas corresponding to areas of weak electrical response to light excitations.

4. A method according to claim 2, characterized in that, the working electrode (4) being fed by the generator, with respect to the auxiliary electrode (14), with a positive potential of substantially 10 V, the predetermined time interval being of the order of 25 minutes, the local cristallographic characteristics of the plate are determined by examination of colored coatings visible on the first side at the end of the predetermined time, each colour being representative of a cristallographic plane.

5. A method according to claim 2, characterized in that the electrolyte is constituted of a mixture of equal parts of alcohol and an aqueous solution containing 5% of hydrofluoric acid.

6. A device for the application of the method according to claim 1, characterized in that it comprises:

— a container (1) supplied with an opening (3), the inner wall of its base (2), which is essentially plane, comprising grooves (5), the base (2) of the container (1) comprising channels (6) making these grooves communicate with the outside of the container,

— a pumping system (8) connected to the channels (6) for evacuating the grooves (5) in order to apply in a removable manner a semiconductor plate (4) via a conductive layer (11) deposited on one side of this plate (4) on the inner wall of the base (2) of the container (1),

— removable means (15) for placing an auxiliary electrode (14) in the container (1),

— means (12, 13, 21, 23, 25) for introducing an electrolyte into the container and remove it therefrom,

— and means for electrically connecting a terminal of the generator to the auxiliary electrode, the other terminal of the generator being connected through the opening (3) of the container (1) to said conductive layer (11).

7. A device according to claim 6, characterized in that the connection between the other terminal of the generator and the conductive layer (11) comprises an electrically conductive spring located in said opening (3), this spring being applied by compression on the conductive layer (11) when the pumping system (8) is activated, the spring being connected to the generator.

8. A device according to one of claims 6 and 7, characterized in that said means for introducing and removing the electrolyte comprise a pumping circuit (13, 21, 23) connected on the one hand to an electrolyte tank (35) through a first valve (30) and on the other hand to a channel (12) passing through the side wall of the container (1), this circuit comprising a pump (21) capable of making the electrolyte circulate in the direction from the tank to the container or vice versa, a branch connection (24) for evacuating the electrolyte being disposed between the pump (21) and the first valve (30), this branch connection (24) comprising in series a second valve (29).

9. A device according to claim 6, characterized in that it further comprises a metal support (17) and means for the removable fastening of the base of the container on the support, the support being supplied with inner channels (18) adapted to contain a circulating cooling liquid.

FIG.1

0 103 806

FIG. 2

0 103 806